# EUROPÄISCHE PATENTANMELDUNG

(11) **EP 1 327 860 A2**
(43) Veröffentlichungstag der Anmeldung: **16.07.2003**
(21) Anmeldenummer: 03090010.4
(22) Anmeldetag: 11.01.2003
(51) Int. Cl.: G01D 5/12

(54) **Stufenlos einstellbarer Regler mit Schalterfunktion**

(30) Priorität: 14.01.2002 DE 10201196
(71) Anmelder: Völckers, Oliver, 54294 Trier (DE)
(72) Erfinder: Volckers, Oliver, 54294 Trier (DE)
(74) Vertreter: Burghardt, Dieter, Dipl.-Ing.

(57) **Zusammenfassung**

Die Erfindung löst die Aufgabe, einen Regler mit integriertem Schalter unter Einsatz eines Sensorstreifens und ein Verfahren zur stufenlosen Einstellung von Kenngrößen elektrischer Geräte einschließlich der Wahl festgelegter Schaltstellungen des Schalters mit integriertem Regler zu entwickeln, dadurch, daß als stufenloser Regler ein berührungsempfindlicher Sensorstreifen vorgesehen ist, der mit einer die durch Berührung des Sensorstreifens durch einen Finger hervorgerufenen Informationen auswertenden und die Berührposition ermittelnden Elektronik verbunden ist, wobei die Elektronik als ein die Steuerung einer Kenngröße auf einen definierten Wert regelnder Regelkreis ausgebildet ist, wobei die errechnete Regelgröße proportional der Berührposition auf dem Sensorstreifen entspricht.

Die Erfindung wird als elektrischer Schalter, der mit einem stufenlosen Regler gekoppelt ist, wirksam.

## Beschreibung

Diese Erfindung betrifft einen elektrischen Schalter, der mit einem stufenlosen Regler gekoppelt ist, wobei der stufenlose Regler aus einem berührempfindlichen Sensorstreifen besteht, mit dem durch eine Finger-Berührung auf die sichtbar und fühlbar hervorgehobenen Positionen auf dem Streifen auf "Aus" bzw. "Ein" geschaltet werden kann und die entsprechenden Zwischenstufen während einer Berührung durch Betätigung der dazwischen liegenden Positionen auf dem Sensorstreifen eingestellt werden können.

Der kombinierte Schalter-Regler ist geeignet zur Regelung von elektrischen Kenngrößen wie Licht (Dimmer) oder Lautstärke, aber auch zur Einstellung der Kraft motorgetriebener Geräte wie Küchenmixer oder Fön und zur Wahl von Zielpositionen etwa bei elektrischen Auto-Fensterhebern oder motorgetriebenen Toren.

Es gibt eine Vielzahl von Konstruktionen für Schalter und Regler, doch nur wenige davon verfügen über einen Schalter kombiniert mit einer stufenlosen Regelung.

Als einfache Lösung läßt sich eine Steuerung eines elektronischen Regelkreises mit wenigen digitalen Tasten realisieren, etwa mit den Funktionen "+" und "-". Zwischenstufen werden in regelmäßigen Zeitabständen weitergezählt, so daß jede Stufe nach entsprechender Wartezeit erreichbar ist. Zusätzlich sind noch Taster für die Funktionen "ein" und "aus" möglich, die ein direktes Schalten auf den Ruhe- und Maximalzustand erlauben.

Eine bekannte Lösung für Dimmer kommt mit einer einzigen Taste aus. Ein kurzer Tastendruck schaltet die Leuchte an bzw. wieder aus, während eine längere Auslösung die Helligkeit allmählich erhöht bzw. verringert. Wartezeiten sind nötig, um Zwischenwerte einzustellen.

Drehschalter mit digitalen Impulsgebern (JogDial) erlauben eine leichte Erhöhung und Absenkung von Kenngrößen. Allerdings registriert die Elektronik nur relative Bewegungen und keine absolute Stellung des Drehschalters, was eine gezielte Einstellung erschwert.

Schieberegler ermöglichen auf einfache Weise die Einstellung von Minimal- und Maximalwerten, eine Kombination mit Schaltern ist jedoch aufwendig.

Drehregler (insbesondere Potentiometer) sind weit verbreitet, auch in Kombination mit Schaltern; etwa bei Autoradios.

Sensorstreifen in der Form von Linear-Potentiometern werden vereinzelt für die Einstellung analoger Werte genutzt.

Die Lösungen mit Tasten sind zwar mechanisch robust und preisgünstig herzustellen, ermöglichen jedoch keine direkte Einstellung von Werten, sondern verlangen systemspezifische Wartezeiten. Der JogDial bietet zwar größeren Komfort als einzelne Tasten, ermöglicht aber auch keine gezielte Ansteuerung von bestimmten Werten.

Die herkömmlichen Potentiometer wie Schiebe- und Drehregler lassen sich nur aufwendig mit Schaltern kombinieren, sind mechanisch aufwendig und vergleichsweise wegen Verschleiß störanfällig. Außerdem ist der Platzbedarf von Potentiometern erheblich größer als der von Schaltern, was sich bei kompakten Geräten durchaus bemerkbar macht.

Die bekannten Sensorstreifen zur Einstellung von Kenngrößen sind schwierig zu bedienen, weil die aktivierbare Fläche nicht fühlbar ist und weil keine Schaltpositionen mit ihnen verbunden sind. Ähnlich wie bei einer Folientastatur ist es leicht möglich, daneben zu greifen; ihre Bedienung erfordert daher besondere Aufmerksamkeit. Deshalb haben Sensorstreifen bisher auch noch keine größere Bedeutung erlangt.

Die Erfindung bezweckt einerseits, daß ein kombinierter Regler-Schalter auf Anhieb verständlich und möglichst mit beliebigen Zwischenstufen ohne Wartezeit wählbar, ohne auf den Schalter schauen zu müssen, bedienbar ist und andererseits preisgünstig in der Herstellung und außerdem im Betrieb robust gegenüber Verschmutzung und Erschütterungen ist und weitgehend verschleißfrei arbeitend einsetzbar ist.

Der Erfindung liegt die Aufgabe zugrunde, einen Regler mit integriertem Schalter unter Einsatz eines Sensorstreifens und ein Verfahren zur stufenlosen Einstellung von Kenngrößen elektrischer Geräte einschließlich der Wahl festgelegter Schaltstellungen des Schalters mit integriertem Regler zu entwickeln.

Die Aufgabe wird durch die im kennzeichnenden Teil genannten Merkmale der unabhängigen Patentansprüche gelöst.

Die Erfindung soll nachfolgend an einem Ausführungsbeispiel näher erläutert werden. In der zugehörigen Zeichnung zeigen:
- Fig. 1: einen Erfindungsgemäß ausgebildeten Regler mit Schalterfunktion in Ansicht
- Fig. 2: einen Erfindungsgemäß ausgebildeten Regler mit Schalterfunktion im Querschnitt
- Fig. 3: Blockschaltbild der Komponenten

- Fig. 4: Variante eines Reglers mit Schalterfunktion mit Einschaltposition geringer als 100%
- Fig. 5: Variante eines Reglers mit Schalterfunktion mit Vorwärts- und Rückwärtsgang
- Fig. 6: ein Flußdiagramm der Ablaufschritte zur Auswertung der Sensorinformation

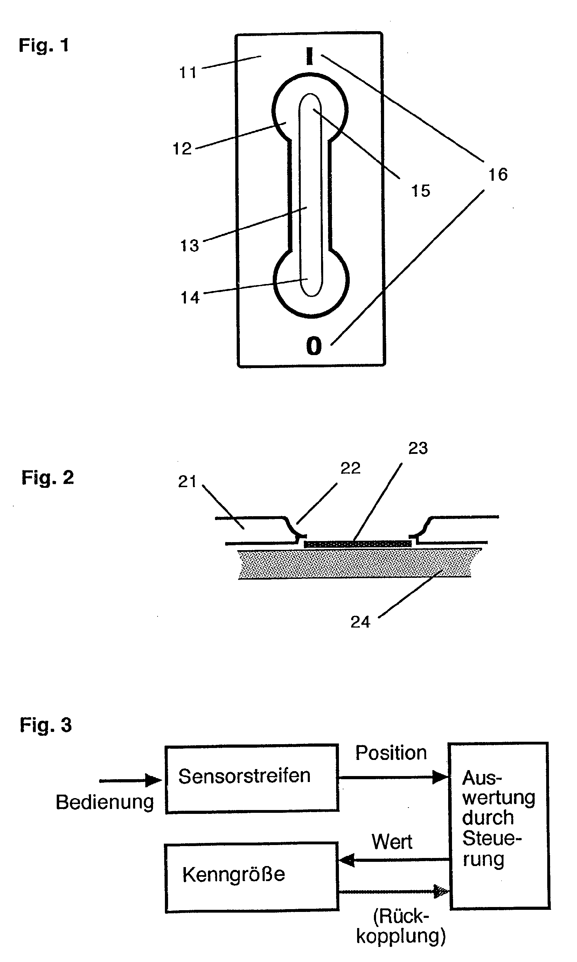

In Fig. 1 ist ein erfindungsgemäß ausgebildeter Reglers mit Schalterfunktion zu sehen. Ein Gehäuse oder eine Frontplatte 11 enthält eine längliche, abgerundete Vertiefung 12 mit einem darin liegenden Sensorstreifen 13. Dieser Sensorstreifen verfügt über die Schaltstellungen "aus" 14 und "an" 15 auf dem Sensorstreifen, die jeweils mit einer Beschriftung 16 markiert sind.

Der gleiche Regler mit Schalterfunktion ist in Fig.2 im Querschnitt gezeigt. Hier ist zu sehen, wie das Gehäuse bzw. die Frontplatte 21 über eine abgerundete Kante 22 eine Öffnung enthält, über die der Sensorstreifen 23 mit dem Finger ausgelöst werden kann. Die Kante 22 ist so konstruiert, daß sie den Sensorstreifen 23 geringfügig überdeckt und dadurch mechanisch hält, wobei durch die Kannten 22 eine Führung für den Finger vorhanden ist. Sowohl das Oberteil 21 als auch der Sensorstreifen 23 liegen in dieser Realisierung auf einer Basisplatte 24; das Oberteil 21 und die Basisplatte 24 können jedoch auch aus einem einzelnen Kunststoffteil bestehen.

Fig. 3 stellt den Informationsfluß zwischen den Komponenten dar. Eine Berührung des Sensorstreifens mit dem Finger führt dazu, daß die Information über die berührte Position an die Steuerung übermittelt und dort ausgewertet wird. Entsprechend der Anwendung wird die gekoppelte Kenngröße dann von der Steuerung auf den gewünschten Wert eingestellt.

Dazu muß der Sensorstreifen in der Lage sein, zwischen dem Ruhezustand und einer Aktivierung zu unterscheiden und die Position einer Betätigung als Punkt auf einer Achse feststellen können. Die Steuerung muß in der Lage sein, die Kenngröße innerhalb des festgelegten Bereichs beliebig einstellen zu können.

Die einzustellende Kenngröße kann entweder dem Zielwert unmittelbar folgen, etwa bei einer Helligkeitssteuerung oder einem Küchenmixer. Bei anderen Kenngrößen ist der Zielwert nur mit einer Verzögerung erreichbar, etwa bei der Temperaturwahl eines Backofens oder elektrischen Rolläden von Fenstern. In diesem Fall kann, wie in Fig. 3 angedeutet, eine Rückkopplung von der Kenngröße zu der Steuerung sinnvoll sein.

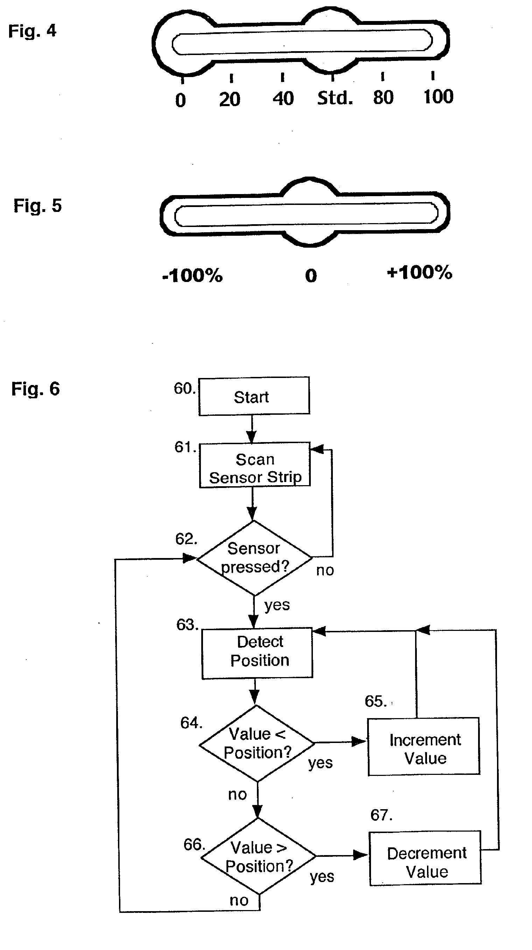

Anstelle der in den meisten Fällen zweckmäßigen Version mit zwei festen Schaltstellungen jeweils an den beiden Enden sind auch andere Varianten möglich: Fig. 4 zeigt einen erfindungsgemäß ausgebildeten Schalter-Regler, dessen Standard-Einschaltzustand unterhalb der Maximalstellung liegt. Das kann z.B. für einen Küchenmixer oder Staubsauger sinnvoll sein: die maximal mögliche Kraft wird nur selten gebraucht, soll aber zugänglich sein.

Eine andere Variante ist in Fig. 5 zu sehen. Hier ist eine Einstellung in zwei Richtungen ausgehend von dem Grundzustand Null vorgesehen. So kann z.B. der Motor eines Akkuschraubers vorwärts und rückwärts stufenlos geregelt werden.

Als Sensorstreifen können jegliche elektronische Sensoren verwendet werden, die auf eine leichte Fingerberührung ansprechen und die berührte Position mit hinreichender Genauigkeit (Abweichung max. rund 5%) an die Steuerung melden. Geeignet sind z.B. sogenannte FSR-Linearpotenziometer (FSR = Force Sensing Resistor), aber auch kapazitive Sensoren.

Der Sensorstreifen kann mit einer Skala von Leuchtpunkten versehen werden, um den erreichten Zustand zu verdeutlichen. Dies ist dann sinnvoll, wenn der Wert der Kenngröße nicht unmittelbar von der Bedienperson wahrgenommen werden kann, etwa bei einem ferngesteuerten Dimmer. Eine Leuchtskala ist aber auch nützlich, wenn die Zielgröße aufgrund materieller Bedingungen nur mit Verzögerung eingestellt werden kann, etwa bei einem motorgetriebenen Tor.

Fig. 6 zeigt die Ablaufschritte zur Auswertung der Sensorinformation. Dabei werden die Bezeichnungen "Position" für das Sensor-Signal und "Value" für die Kenngröße verwendet.

Nach dem Start 60 überprüft die Mikroprozessorsteuerung in Schritt 61 und 62, ob der Sensorstreifen berührt wurde. Falls ja, wird in Schritt 63 die Position der letzten Berührung ermittelt, bei der üblichen Anordnung im Bereich null bis 100%.

Liegt in Schritt 64 der Wert "Value" der Kenngröße unter dem gewünschten Zielwert, der identisch ist mit der Berühr-Position, so wird die Kenngröße in Schritt 65 erhöht. Dies wird so oft wie notwendig wiederholt.

Liegt in Schritt 66 der Wert "Value" der Kenngröße über dem gewünschten Zielwert, so wird die Kenngröße in Schritt 67 abgesenkt. Auch dies wird wiederholt, falls notwendig.

Die Schritte 63 bis 67 gewährleisten, daß die Kenngröße solange in Richtung des Zielwerts verändert wird, bis dieser erreicht ist. Dann setzt die Steuerung mit Schritt 62 fort. Bei einer verzögerungslosen Steuerung wie z.B. einem Dimmer garantiert dieser Ablauf, daß die Kenngröße dem gewählten Zielwert direkt folgt.

Bei einer Steuerung mit Verzögerung (Backofen, elektrische Fensterheber usw.) kann der Sensorstreifen losgelassen werden, bevor der Zielwert der Kenngröße erreicht ist. In den meisten Anwendungen mit verzögerter Steuerung ist es sinnvoll, den Zielwert durch eine einfache Berührung an der gewünschten Position zu wählen (z.B. Backofen-Temperaturwahl, Rolladen-Steuerung).

Es gibt jedoch auch Anwendungen, in denen die Bedienung der gesteuerten Geräte mit potenziellen Gefahren verbunden ist, etwa beim Schließen eines elektrisch angetriebenen Fensters. In diesen Fällen kann es sinnvoll sein, den Antrieb nur solange laufen zu lassen, wie der Sensorstreifen berührt wird. Ein Loslassen des Streifens führt dann zu einem sofortigen Stopp des Antriebs. Dieses Verhalten läßt sich mit der gleichen Steuerung erreichen, wenn in Abweichung von dem Ablauf von Fig. 6 die Schritte 65 und 67 mit Schritt 62 anstatt 63 fortgesetzt werden. Dann wird nach jeder Veränderung der Kenngröße erneut überprüft, ob der Sensorstreifen noch berührt wird und im negativen Fall die Regelung abgebrochen (Schritt 62, dann 61).

Im Vergleich zu Steuerungen mit Tasten zum manuellen Einstellen bietet dieser Mechanismus eine wesentlich schnellere und komfortablere Einstellmöglichkeit. Da die Erfindung eine Direktwahl bestimmter Stufen erlaubt, würden für eine entsprechende Tastensteuerung mindestens vier Tasten benötigt. Der erfindunggemäß ausgebildete Schalter ist auch wesentlich einfacher zu bedienen, da die Schaltstufen auf der gleichen Linie wie die Regelung angebracht sind.

Im Vergleich zu der bekannten Dimmersteuerung mit einer einzigen Taste ist der erfindungsgemäß ausgebildete Schalter ohne Wartezeiten bedienbar und ermöglicht beliebiges Hoch- und Herunterregeln, während die nach dem Stand der Technik bekannte Dimmersteuerung immer einen vorgegebenen Zyklus durchlaufen muß. Außerdem ist der erfindungsgemäß ausgebildete Schalter vielseitiger, da der Erfindungsgegenstand im Gegensatz zu den bekannten Lösungen auch Kenngrößen mit Verzögerung steuern kann, also z.B. elektrische Fensterheber.

Während die Impulsgeber von JogDials nur eine Drehbewegung in relative Änderungen umsetzen können, bietet der Erfindungsgegenstand eine direkte Anwahl des Zielwerts und ist somit schneller zu bedienen. JogDials können Kenngrößen mit Verzögerung nur in Verbindung mit einem Display oder einer sichtbaren Rückkopplung steuern, da die Bewegung des JogDials nicht mit einer bestimmten Position assoziiert werden kann.

Im Vergleich zu Schiebe- und Drehpotentiometern benötigt der Erfindungsgegenstand weniger Platz und ist robuster gegenüber Staub, Feuchtigkeit und Verschleiß. Außerdem erlaubt der Erfindungsgegenstand eine etwas schnellere Anwahl von Zielwerten, da nur eine einzelne Berührung an der gewünschten Position nötig ist, während bei Potentiometern erst ein Griff an die Zielposition bewegt werden muß.

Anders als bekannte Sensorstreifen ermöglicht die Erfindung eine Anwahl von Positionen ohne Hinschauen, da die Stellungen des Streifens fühlbar sind. Dies ermöglicht erst eine Nutzung für Anwendungen wie elektrische Fensterheber von Autos. Durch die sichtbare und tastbare Hervorhebung bestimmter Stufen kann die Erfindung sowohl existierende Schalter als auch Regler durch ein integriertes Konzept ersetzen.

Die freie Wahl der hervorgehobenen Stufen ermöglicht einen vielseitigen Einsatz und eine jeweils spezifische Anpassung. Die Regelung kann so unterschiedliche Aufgaben abdecken wie die Steuerung von Dimmern, Küchenmixern, Akkuschraubern, Staubsaugern, Föns, elektrischen Fenstern und Rolläden, Backofen-Temperaturen, Zoom-Objektiven von Kameras, Kinderspielzeug, Gabelstaplern und vieles mehr.

## Patentansprüche

1. Stufenlos einstellbarer Regler mit Schalterfunktion, ***dadurch gekennzeichnet,* daß** als Regler ein berührungsempfindlicher Sensorstreifen vorgesehen ist, der mit einer die durch Berührung des Sensorstreifens hervorgerufenen Informationen auswertenden und die Berührposition ermittelnden Elektronik verbunden ist, wobei die Elektronik als ein die Steuerung einer Kenngröße auf einen definierten Wert regelnder Regelkreis ausgebildet ist, wobei die errechnete Regelgröße proportional der Berührposition auf dem Sensorstreifen entspricht.

2. Stufenlos einstellbarer Regler mit Schalterfunktion nach Anspruch 1, ***dadurch gekennzeichnet,* daß** der Sensorstreifen entweder aus einem sogenannten FSR (Force Sensing Resistor) in Form eines Linearpotentiometers, aus einem kapazitiven Sensor oder aus einer Vielzahl von Folienschaltern besteht.

3. Stufenlos einstellbarer Regler mit Schalterfunktion nach Anspruch 1 und 2, ***dadurch gekennzeichnet,* daß** die Folienschalter räumlich in Reihe und elektrisch als Matrix in für Tastaturen üblichen Abtastungen angeordnet sind.

4. Stufenlos einstellbarer Regler mit Schalterfunktion nach Anspruch 1 bis 3, ***dadurch gekennzeichnet,* daß** der Sensorstreifen eine Länge von 2 bis 15 cm und eine Breite ca. 2 bis 8 mm aufweist.

5. Stufenlos einstellbarer Regler mit Schalterfunktion nach Anspruch 1 bis 4, ***dadurch gekennzeichnet,* daß** der Sensorstreifen in einer ca. 0,5 bis 2mm tiefen, sichtbaren, fühlbaren und abgerundeten Vertiefung angeordnet ist.

6. Stufenlos einstellbarer Regler mit Schalterfunktion nach Anspruch 1 bis 5, ***dadurch gekennzeichnet,* daß** der Sensorstreifen über eine oder mehrere hervorgehobene Positionen verfügt, die bestimmten Schaltstufen entsprechen.

7. Stufenlos einstellbarer Regler mit Schalterfunktion nach Anspruch 1 bis 6, ***dadurch gekennzeichnet,* daß** der Sensorstreifen zwecks Markierung eines Regelzustandes mit einer Skala von Leuchtpunkten versehen ist.

8. Stufenlos einstellbarer Regler mit Schalterfunktion nach Anspruch 1 bis 7, ***dadurch gekennzeichnet,* daß** der berührungsempfindliche Sensorstreifen in Verbindung mit einer der Verarbeitung der durch eine Berührung des Sensorstreifens hervorgerufenen Informationen als regelungstechnische Störgrößen beaufschlagbaren Auswerteelektronik sowohl in datenverarbeitende elektronische Einrichtungen, in der Audio- und Videotechnik als auch zur Regelung elektrischer Stromversorungseinrichtungen für ohmsche Verbraucher einsetzbar ausgeführt ist.

9. Verfahren zur stufenlosen Einstellung von Kenngrößen an einem Regler mit Schalterfunktion nach Anspruch 1 bis 8, ***dadurch gekennzeichnet,* daß** eine Berührung des Sensorstreifens mit einem Finger zu einer Anzeige eines der Position des Fingers entsprechenden Information führt, worauf die Berührposition bis zur genauen Auswahl eines bestimmten Kennwertes auf dem Sensorstreifen noch bewegt werden kann, nach Erreichen der genauen, einem bestimmten Kennwert entsprechenden Berührungsposition der Sensorstreifen losgelassen wird und dadurch die zuletzt hervorgerufene Berührungsposition als Eingabe für einen bestimmten Kennwert errechnet wird.

10. Verfahren zur stufenlosen Einstellung von Kenngrößen an einem Regler mit Schalterfunktion nach Anspruch 9, ***dadurch gekennzeichnet,* daß** nach Feststellung der Berührung des Sensorstreifens aus der ermittelten Berührungsposition auf dem Sensorstreifen der dieser Position zugeordnete eingegebene Positionswert errechnet und sodann als Kennwert für die Regelung ermittelt wird, solange die Berührung des Sensorstreifens fortbesteht, der aktuelle, der Berührungsposition entsprechende Kennwert dargestellt und erst nach Aufgabe der Betätigung der Eingabewertes akzeptiert wird.

11. Verfahren zur stufenlosen Einstellung von Kenngrößen an einem Regler mit Schalterfunktion nach Anspruch 9 und 10, ***dadurch gekennzeichnet,* daß** die Berührposition in einem Speicher gehalten wird, bis die Kenngröße auf den Zielwert eingestellt ist.
